# EUROPÄISCHE PATENTSCHRIFT

(11) **EP 2 621 750 B1**
(45) Veröffentlichungstag und Bekanntmachung des Hinweises auf die Patenterteilung: **29.10.2014**
(21) Anmeldenummer: 11743972.9
(22) Anmeldetag: 08.08.2011
(51) Int. Cl.: B60K 37/06, H03K 17/96, H03K 17/97, H01H 13/85

(54) **SCHALTVORRICHTUNG**
SWITCHING DEVICE
DISPOSITIF DE COMMUTATION

(30) Priorität: 01.10.2010 DE 102010047261
(43) Veröffentlichungstag der Anmeldung: 07.08.2013
(73) Patentinhaber: TRW Automotive Electronics & Components GmbH, 78315 Radolfzell (DE)
(72) Erfinder: KORHERR, Joachim, 78359 Orsingen (DE)
(74) Vertreter: Prinz & Partner mbB
(86) Internationale Anmeldenummer: PCT/EP2011/003970
(87) Internationale Veröffentlichungsnummer: WO 2012/041417

(56) Entgegenhaltungen:
- DE-A1- 10 318 376
- DE-C1- 4 230 950

## Beschreibung

Die Erfindung betrifft eine Schaltvorrichtung, insbesondere in Kraftfahrzeugen.

Aus dem Stand der Technik sind sowohl berührungssensitive Schaltvorrichtungen wie z.B. Touchpads, als auch taktile Schaltvorrichtungen wie z.B. mechanische Wipp- oder Tastschalter bekannt. Beim Schalten taktiler Schaltvorrichtungen ist ein Schaltweg zu überwinden, der beispielsweise durch Verwendung einer Schaltmatte oder Schnappscheibe eine definierte Kraft-Weg-Kennlinie aufweist. Demgegenüber sind fühlbare Rückmeldungen an den Bediener bei berührungssensitiven Schaltern nicht zwangsläufig vorhanden, können aber durch Klopfer oder Ähnliches erzeugt werden. Die dabei entstehende Rückmeldung fühlt sich für den Bediener jedoch nicht wie die gewohnte und gewünschte Rückmeldung einer taktilen Schalttaste an.

In der gattungsbildenden DE 103 18 376 A1 ist eine haptische Bedieneinrichtung, insbesondere für Kraftfahrzeuge beschrieben, mit einer Anzeigeeinrichtung, einem Tastmittel, einem Stellelement und einem Schaltmittel, wobei das Tastmittel ein Sichtfenster aufweist, die Anzeigeeinrichtung zumindest teilweise durch das Sichtfenster optisch wahrnehmbar ist, das Tastmittel in wenigstens einer Raumrichtung relativ zur Anzeigeeinrichtung verschieblich und/oder rotierbar ist, das Schaltmittel mittels einer Verschiebung und/oder Rotation des Tastmittels und/oder mittels Druckausübung aktivierbar ist, das Tastmittel mittels des Stellelements in eine Grundposition rückführbar ist und die Anzeigeeinrichtung frei programmierbar ist. Das Schaltmittel ist dabei insbesondere eine drucksensitive Folie und/oder ein Taster und/oder ein Wippschalter und/oder eine elektrisch leitende Kontaktierung oder dergleichen, während als Stellelement beispielsweise ein Federelement, ein elektromechanischer Aktuator, ein pneumatischer Aktuator oder dergleichen zum Einsatz kommen kann.

Aufgabe der Erfindung ist die Schaffung einer energieeffizient und berührungssensitiv arbeitenden Schaltvorrichtung, die (bevorzugt wahlweise) ein mit taktilen Schaltvorrichtungen vergleichbares Schaltgefühl vermitteln kann.

Erfindungsgemäß wird diese Aufgabe gelöst durch eine Schaltvorrichtung, insbesondere in Kraftfahrzeugen, mit einem verstellbaren, berührungsempfindlichen Schaltelement, welches durch einen in einer Betätigungsrichtung ausgeübten Berührdruck schaltbar ist, wobei das Schaltelement eine erste Ausgangsstellung einnehmen kann, in der sich das Schaltelement in Betätigungsrichtung an einem Widerlager abstützt, und wobei das Schaltelement eine zweite Ausgangsstellung einnehmen kann, in der das Schaltelement gegenüber der ersten Ausgangsstellung um einen vorbestimmbaren Weg entgegen der Betätigungsrichtung verstellt ist. Das berührungsempfindliche Schaltelement lässt sich somit zwischen seiner ersten Ausgangsstellung, in der eine Bewegung in der Betätigungsrichtung blockiert ist (berührungssensitives Schalten ohne taktile Rückmeldung), und seiner zweiten Ausgangsstellung, in der eine Bewegung in der Betätigungsrichtung möglich ist (berührungssensitives Schalten mit taktiler Rückmeldung), verstellen. Der vorbestimmte Weg zwischen den beiden Ausgangsstellungen kann dabei als "virtueller Schaltweg" angesehen werden, da er in der zweiten Ausgangsstellung des Schaltelements trotz einem weiterhin berührungssensitiven Schaltvorgang das Schaltgefühl einer traditionellen Schaltmechanik mit Schaltweg vermittelt.

Ferner ist ein zwischen zwei Endpositionen bewegbarer Dauermagnet vorgesehen, der das Schaltelement entgegen der Betätigungsrichtung vom Widerlager weg beaufschlagen kann. Dieser Dauermagnet ermöglicht damit eine einfache Verstellung des Schaltelements zwischen seinen beiden Ausgangsstellungen.

In einer Ausführungsform der Schaltvorrichtung ist eine Feder vorgesehen, die das Schaltelement in Betätigungsrichtung gegen das Widerlager beaufschlagt. Die Feder erzeugt somit eine Vorspannung, welche für klar definierte und klapperfreie Schaltstellungen der Schaltvorrichtung sorgt.

In einer ersten Endposition des bewegbaren Dauermagneten ist dabei eine entgegen der Betätigungsrichtung auf das Schaltelement wirkende Magnetkraft des Dauermagneten vorzugsweise kleiner als eine in der Betätigungsrichtung auf das Schaltelement wirkende Federkraft der Feder. Durch ein derartiges Kräfteverhältnis wird sichergestellt, dass das Schaltelement in der ersten Endposition des Dauermagneten seine erste Ausgangsstellung einnimmt.

Hingegen ist in einer zweiten Endposition des bewegbaren Dauermagneten eine entgegen der Betätigungsrichtung auf das Schaltelement wirkende Magnetkraft des Dauermagneten vorzugsweise größer als eine in der Betätigungsrichtung auf das Schaltelement wirkende Federkraft der Feder. Durch dieses Kräfteverhältnis wird entsprechend sichergestellt, dass sich das Schaltelement in der zweiten Endposition des Dauermagneten in seiner zweiten Ausgangsstellung befindet.

Idealerweise ist somit die Ausgangsstellung des Schaltelements unmittelbar an die Endposition des Dauermagneten gekoppelt.

Besonders bevorzugt entspricht die aus dem Berührdruck resultierende, zum Schalten des Schaltelements notwendige Schaltkraft in der zweiten Endposition des Dauermagneten betragsmäßig im Wesentlichen der Differenz aus Magnetkraft und Federkraft. Dadurch setzt in der zweiten Endposition des Dauermagneten eine taktile Rückmeldung der Schaltvorrichtung im Wesentlichen zeitgleich mit dem berührungssensitiv ausgelösten Schaltvorgang des Schaltelements ein.

In einer weiteren Ausführungsform der Schaltvorrichtung ist eine bestrombare Magnetspuleneinheit mit einer Spulenachse vorgesehen, wobei der Dauermagnet wenigstens teilweise in der Magnetspuleneinheit aufgenommen und in axialer Richtung zwischen einer ersten Endposition und einer zweiten Endposition bewegbar ist. Durch entsprechende Bestromung der Magnetspuleneinheit lässt sich der Dauermagnet folglich mit geringem Aufwand zwischen seinen beiden Endpositionen verstellen.

Die Spulenachse erstreckt sich dabei vorzugsweise im Wesentlichen parallel zur Betätigungsrichtung des berührungsempfindlichen Schaltelements.

Die Magnetspuleneinheit weist in der ersten Endposition des Dauermagneten bevorzugt eine andere Induktivität auf als in der zweiten Endposition des Dauermagneten, wobei eine Einrichtung zum Messen der Induktivität der Magnetspuleneinheit vorgesehen ist. Somit lässt sich jederzeit die Position des Dauermagneten bestimmen und damit auch eine Information gewinnen, ob ein Schaltvorgang der Schaltvorrichtung mit oder ohne taktile Rückmeldung erfolgt.

In einer weiteren Ausführungsform der Schaltvorrichtung ist ein erstes magnetisierbares Bauteil, insbesondere ein erstes Magnetjoch einer Magnetspuleneinheit, vorgesehen, das bei unbestromter Magnetspuleneinheit den Dauermagneten in einer axialen ersten Endposition durch eine Magnetkraft axial fixiert. Dies ist energetisch äußerst vorteilhaft, da somit ohne Energiebedarf der Magnetspuleneinheit ein berührungssensitives Schalten der Schaltvorrichtung ohne taktile Rückmeldung ermöglicht wird.

Besonders bevorzugt ist (zusätzlich) ein zweites magnetisierbares Bauteil, insbesondere ein zweites Magnetjoch einer Magnetspuleneinheit, vorgesehen, das bei unbestromter Magnetspuleneinheit den Dauermagneten in einer axialen zweiten Endposition durch eine Magnetkraft axial fixiert. Dies ist energetisch äußerst vorteilhaft, da somit ohne Energiebedarf der Magnetspuleneinheit ein berührungssensitives Schalten der Schaltvorrichtung mit taktiler Rückmeldung ermöglicht wird.

In einer weiteren Ausführungsform der Schaltvorrichtung ist das berührungsempfindliche Schaltelement mit einem im Wesentlichen koaxial zum Dauermagneten ausgerichteten, axial beweglichen, magnetisierbaren Körper gekoppelt.

Hierbei können das berührungsempfindliche Schaltelement an einem ersten Hebelarm und der magnetisierbare Körper an einem zweiten Hebelarm eines zweiarmigen Hebels befestigt sein.

Alternativ kann das berührungsempfindliche Schaltelement mit dem magnetisierbaren Körper verbunden und gemeinsam mit dem magnetisierbaren Körper in axialer Richtung bewegbar sein. Dies führt zu einem kompakten und konstruktiv einfachen Aufbau der Schaltvorrichtung, was sich letztlich auch vorteilhaft auf die Herstellungskosten auswirkt.

Weitere Merkmale und Vorteile der Erfindung ergeben sich aus der nachfolgenden Beschreibung bevorzugter Ausführungsformen unter Bezugnahme auf die Zeichnungen. In diesen zeigen:
- Figur 1 eine schematische Skizze einer erfindungsgemäßen Schaltvorrichtung gemäß einer ersten Ausführungsform, mit einem Schaltelement in einer ersten Ausgangsstellung;
- Figur 2 eine schematische Skizze der erfindungsgemäßen Schaltvorrichtung gemäß Figur 1, mit dem Schaltelement in einer zweiten Ausgangsstellung;
- Figur 3 ein Diagramm mit einer Kraft/Weg-Kennlinie, die sich beim Schaltvorgang der Schaltvorrichtung gemäß Figur 2 einstellt;
- Figur 4 eine schematische Skizze einer erfindungsgemäßen Schaltvorrichtung gemäß einer zweiten Ausführungsform, mit einem Schaltelement in einer ersten Ausgangsstellung;
- Figur 5 eine schematische Skizze der erfindungsgemäßen Schaltvorrichtung gemäß Figur 4, mit dem Schaltelement in einer zweiten Ausgangsstellung; und
- Figur 6 eine schematische Skizze der erfindungsgemäßen Schaltvorrichtung gemäß Figur 5 nach dem Aufbringen einer Schaltkraft.

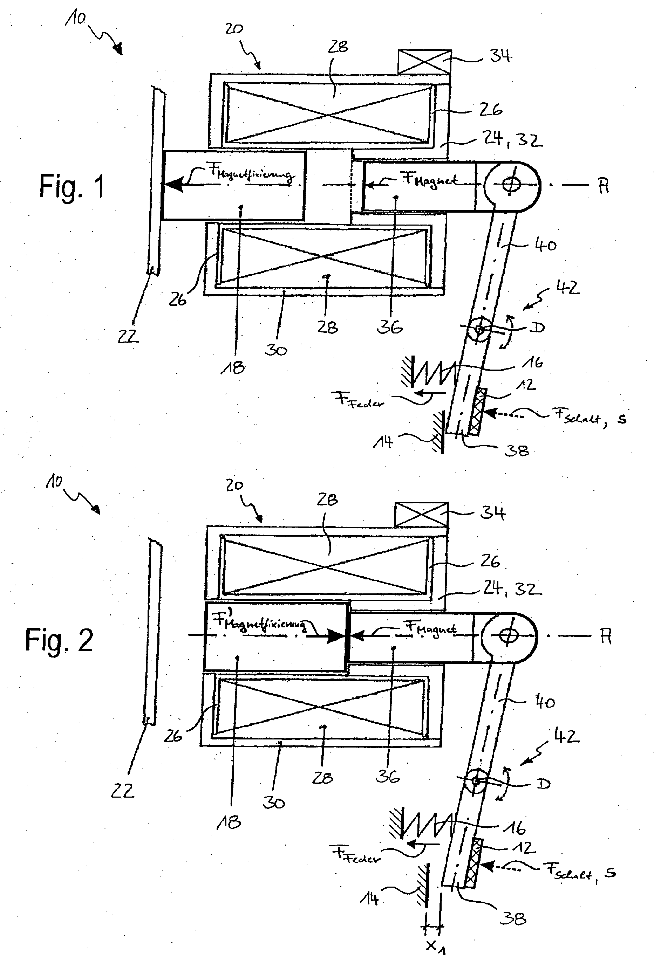

Die Figuren 1 und 2 zeigen eine erste Ausführungsform einer Schaltvorrichtung 10, insbesondere in Kraftfahrzeugen, mit einem verstellbaren, berührungsempfindlichen Schaltelement 12, welches durch einen in einer Betätigungsrichtung s ausgeübten Berührdruck schaltbar ist. Das berührungsempfindliche Schaltelement 12 ist dabei zum Beispiel ein allgemein bekanntes, berührungssensitives kapazitives Feld wie es beispielsweise auch bei herkömmlichen Touchpads eingesetzt wird.

Das berührungsempfindliche Schaltelement 12 befindet sich in Figur 1 in einer ersten Ausgangsstellung, in welcher sich das Schaltelement 12 in der Betätigungsrichtung s an einem Widerlager 14 abstützt. Dies bedeutet, dass das Schaltelement 12 bei in Betätigungsrichtung s ausgeübtem Berührdruck geschaltet wird, ohne dass es sich für den Bediener spürbar bewegt. Mit anderen Worten weist die Schaltvorrichtung 10 beim Schalten keine taktile Rückmeldung auf, wenn sich das Schaltelement 12 in seiner ersten Ausgangsstellung befindet. Der Schaltvorgang erfolgt rein berührungssensitiv.

Die Figur 2 zeigt eine Skizze der Schaltvorrichtung 10 gemäß Figur 1, wobei sich das Schaltelement 12 in einer zweiten Ausgangsstellung befindet, in der das Schaltelement 12 gegenüber der ersten Ausgangsstellung um einen vorbestimmbaren Weg x₁ entgegen der Betätigungsrichtung s verstellt ist. Dementsprechend lässt sich das Schaltelement 12 in seiner Betätigungsrichtung s um den Weg x₁ verstellen. Der vorbestimmbare Weg x₁ kann in diesem Fall auch als "virtueller Schaltweg" bezeichnet werden, da er dem Bediener eine taktile Rückmeldung vermittelt. Der eigentliche Schaltvorgang läuft jedoch nach wie vor rein berührungssensitiv ab, genau wie in Figur 1.

Ein Bediener der Schaltvorrichtung 10 kann somit wählen zwischen einem berührungssensitiven Schaltvorgang ohne taktile Rückmeldung (vgl. Figur 1) und einem berührungssensitiven Schaltvorgang mit taktiler Rückmeldung (vgl. Figur 2).

Gemäß den Figuren 1 und 2 weist die Schaltvorrichtung 10 eine Feder 16 auf, welche das Schaltelement 12 in der Betätigungsrichtung s gegen das Widerlager 14, das heißt also in die erste Ausgangsstellung gemäß Figur 1, beaufschlagt. Im vorliegenden Fall ist die Feder 16 eine Zugfeder, welche das Schaltelement 12 mit einer Federkraft F_{Feder} gegen das Widerlager 14 beaufschlagt. Statt der Zugfeder kann in alternativen Ausführungsformen selbstverständlich auch eine Druckfeder eingesetzt werden, welche das Schaltelement 12 in der Betätigungsrichtung s gegen das Widerlager 14 beaufschlagt.

Die Schaltvorrichtung 10 umfasst ferner einen zwischen zwei Endpositionen bewegbaren Dauermagneten 18, der das Schaltelement 12 entgegen der Betätigungsrichtung s vom Widerlager 14 weg, das heißt also in die zweite Ausgangsstellung gemäß Figur 2, beaufschlagen kann.

In einer ersten Endposition des bewegbaren Dauermagneten 18 gemäß Figur 1 ist eine entgegen der Betätigungsrichtung s auf das Schaltelement 12 wirkende Magnetkraft F_{Magnet} des Dauermagneten 18 kleiner als eine in der Betätigungsrichtung s auf das Schaltelement 12 wirkende Federkraft F_{Feder} der Feder 16.

Hingegen ist in einer zweiten Endposition des bewegbaren Dauermagneten 18 gemäß Figur 2 die entgegen der Betätigungsrichtung s auf das Schaltelement 12 wirkende Magnetkraft F_{Magnet} des Dauermagneten 18 größer als eine in der Betätigungsrichtung s auf das Schaltelement 12 wirkende Federkraft F_{Feder} der Feder 16.

Folglich ist die erste Ausgangsstellung des Schaltelements 12 unmittelbar an die erste Endposition des Dauermagneten 18 und die zweite Ausgangsstellung des Schaltelements 12 unmittelbar an die zweite Endposition des Dauermagneten 18 gekoppelt, wodurch sich über die Position des Dauermagneten 18 die Ausgangsstellung des Schaltelements 12 einstellen lässt.

In einer besonders bevorzugten Ausführungsvariante entspricht die aus dem Berührdruck resultierende, zum Schalten des Schaltelements 12 notwendige Schaltkraft F_{Schalt} in der zweiten Endposition (Figur 2) des Dauermagneten 18 betragsmäßig im Wesentlichen der Differenz aus Magnetkraft F_{Magnet} und Federkraft F_{Feder}. Ein solches Kräfteverhältnis bietet den Vorteil, dass das berührungssensitive Schalten des Schaltelements 12 im Wesentlichen zeitgleich mit der taktilen Rückmeldung an den Bediener erfolgt. Außerdem wird dadurch sichergestellt, dass bei jedem berührungssensitiven Schaltvorgang eine taktile Rückmeldung erfolgt und umgekehrt.

In den Figuren 1 und 2 ist ferner eine bestrombare Magnetspuleneinheit 20 mit einer Spulenachse A vorgesehen, wobei der Dauermagnet 18 wenigstens teilweise in der Magnetspuleneinheit 20 aufgenommen und in axialer Richtung zwischen der ersten Endposition (Figur 1) und der zweiten Endposition (vgl. Figur 2) bewegbar ist. Ferner ist ein erstes magnetisierbares Bauteil 22 vorgesehen, das den Dauermagneten 18 bei unbestromter Magnetspuleneinheit 20 durch eine Magnetkraft F_{Magnetfixierung} in der ersten Endposition axial fixiert. Das erste magnetisierbare Bauteil 22 ist in der ersten Ausführungsform gemäß den Figuren 1 und 2 ein Eisenblech, welches axial unverschieblich zur Magnetspuleneinheit 20 angeordnet ist. Außerdem ist ein zweites magnetisierbares Bauteil 24 vorgesehen, das den Dauermagneten 18 bei unbestromter Magnetspuleneinheit 20 durch eine Magnetkraft F'_{Magnetfixierung} in der zweiten Endposition axial fixiert.

Die Magnetkräfte F_{Magnetfixierung} und F'_{Magnetfixierung} sind dabei so groß, dass der Dauermagnet 18 nur durch eine Bestromung der Magnetspuleneinheit 20 aus seiner ersten bzw. zweiten Endposition verstellt werden kann.

Die Magnetspuleneinheit 20 umfasst gemäß den Figuren 1 und 2 einen Spulenkörper 26, insbesondere aus Kunststoff, sowie einen Metalldraht 28, insbesondere einen Kupfer-Lackdraht, der auf den Spulenkörper 26 aufgewickelt ist. Darüber hinaus umfasst die Magnetspuleneinheit 20 einen Magnettopf 30, insbesondere aus Eisen, der den gewickelten Metalldraht 28 und den Spulenkörper 26 umschließt, sowie ein Magnetjoch 32, welches in der ersten Ausführungsform der Schaltvorrichtung 10 das zweite magnetisierbare Bauteil 24 bildet (Figur 2).

Die Magnetspuleneinheit 20 weist in der ersten Endposition des Dauermagneten 18 gemäß Figur 1 eine andere Induktivität auf als in der zweiten Endposition des Dauermagneten 18 gemäß Figur 2, wobei eine Einrichtung 34 zum Messen der Induktivität der Magnetspuleneinheit 20 vorgesehen ist. Mittels dieser Einrichtung 34 lässt sich jederzeit mit geringem Aufwand bestimmen, ob sich die Schaltvorrichtung 10 in einem Betriebszustand ohne taktile Rückmeldung eines Schaltvorgangs (erste Ausgangsstellung des Schaltelements 12 gemäß Figur 1) oder in einem Betriebszustand mit taktiler Rückmeldung eines Schaltvorgangs (zweite Ausgangsstellung des Schaltelements 12 gemäß Figur 2) befindet.

Das berührungsempfindliche Schaltelement 12 ist mit einem im Wesentlichen koaxial zum Dauermagneten 18 ausgerichteten, axial beweglichen, magnetisierbaren Körper 36 gekoppelt. Gemäß der ersten Ausführungsform in den Figuren 1 und 2 ist dabei das berührungsempfindliche Schaltelement 12 an einem ersten Hebelarm 38 und der magnetisierbare Körper 36 an einem zweiten Hebelarm 40 eines zweiarmigen Hebels 42 befestigt, wobei der Hebel 42 um einen Drehpunkt D verschwenkt werden kann.

Die Funktion der Schaltvorrichtung 10 ist wie folgt:
In der ersten Endposition des Dauermagneten 18 gemäß Figur 1 ist das aus der Magnetkraft F_{Magnet} resultierende Drehmoment kleiner als das entgegengesetzt wirkende, aus der Federkraft F_{Feder} resultierende Drehmoment, sodass das Schaltelement 12 seine erste Ausgangsstellung einnimmt, in der es sich in seiner Betätigungsrichtung s (permanent) am Widerlager 14 abstützt. Das Schalten der Schaltvorrichtung 10 erfolgt in diesem Fall für den Bediener taktil nicht spürbar, rein berührungssensitiv durch die vom Bediener aufgebrachte Schaltkraft F_{schalt}.

In der zweiten Endposition des Dauermagneten 18 gemäß Figur 2 ist das aus der Magnetkraft F_{Magnet} resultierende Drehmoment größer als das entgegengesetzt wirkende, aus der Federkraft F_{Feder} resultierende Drehmoment, sodass das Schaltelement 12 die zweite Ausgangsstellung einnimmt. Das Magnetjoch 32 der Magnetspuleneinheit 20 bildet einen axialen Anschlag für den Dauermagneten 18, der wiederum einen axialen Anschlag für den magnetisierbaren Körper 36 bildet, sodass die zweite Ausgangsstellung des Schaltelements 12 exakt definiert ist.

Zum Schalten der Schaltvorrichtung 10 wird über den Berührdruck wiederum die erforderliche Schaltkraft F_{schalt} aufgebracht, sodass das Schaltelement 12 berührungssensitiv schaltet. Die Schaltkraft F_{schalt} reicht in diesem Fall jedoch auch aus, um das Schaltelement 12 in seiner Betätigungsrichtung s um den vorbestimmbaren Weg x₁ zu verstellen. Dies geschieht mit Unterstützung der Federkraft F_{Feder} und entgegen der Magnetkraft F_{Magnet} zwischen dem Dauermagneten 18 und dem magnetisierbaren Körper 36.

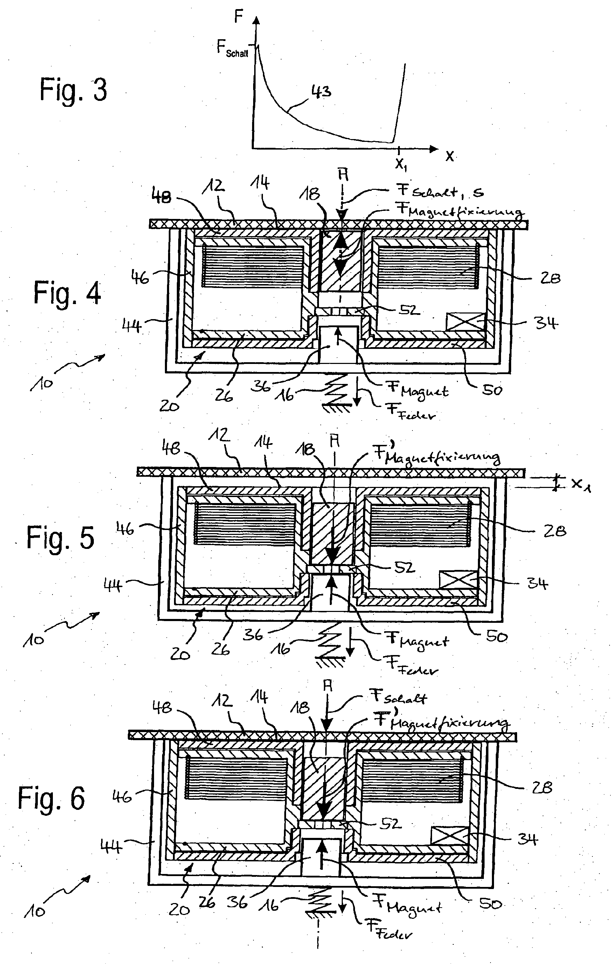

Bei dieser Verstellung des Schaltelements 12 in Betätigungsrichtung s ergibt sich eine Kennlinie 43, wie sie im Diagramm gemäß Figur 3 dargestellt ist, wobei auf der Abszisse ausgehend von der zweiten Ausgangsstellung gemäß Figur 2 der Weg x des Schaltelements 12 in Betätigungsrichtung s und auf der Ordinate die aufgebrachte Kraft F aufgetragen ist. Die dargestellte Kennlinie 43 ist der Kurve eines Schalters mit Schaltmatte oder Schnappscheibe sehr ähnlich, insbesondere dann, wenn der Hebel 42 über eine (nicht eingezeichnete) Druckfeder betätigt wird.

Die Figuren 4 bis 6 zeigen eine zweite Ausführungsform der Schaltvorrichtung 10. Da sich das Funktionsprinzip sowie viele der strukturellen Merkmale nicht von der ersten Ausführungsform gemäß den Figuren 1 und 2 unterscheiden, wird diesbezüglich explizit auf die obige Beschreibung der Figuren 1 bis 3 verwiesen. Um Wiederholungen zu vermeiden, wird im Folgenden lediglich auf strukturelle Unterschiede eingegangen.

Die Figur 4 zeigt analog zu Figur 1 die Schaltvorrichtung 10 mit dem Schaltelement 12 in der ersten Ausgangsstellung während die Figur 5 analog zu Figur 2 die Schaltvorrichtung 10 mit dem Schaltelement 12 in der zweiten Ausgangsstellung zeigt. Ausgehend von Figur 5 zeigt die Figur 6 schließlich die Schaltvorrichtung 10 nach dem Aufbringen der Schaltkraft F_{Schalt}.

Die zweite Ausführungsform der Schaltvorrichtung 10 unterscheidet sich hauptsächlich dadurch von der ersten Ausführungsform, dass das berührungsempfindliche Schaltelement 12 gemäß den Figuren 4 bis 6 mit dem magnetisierbaren Körper 36 verbunden und gemeinsam mit diesem in axialer Richtung bewegbar ist. Das Schaltelement 12 und der magnetisierbare Körper 36 sind im vorliegenden Fall beispielsweise durch Gehäusestege 44 miteinander verbunden und in axialer Richtung relativ zur Magnetspuleneinheit 20 um den vorbestimmbaren Weg x₁ verstellbar.

Wie in den Figuren 4 und 6 zu sehen, wird das Widerlager 14 hier durch die Magnetspuleneinheit 20 gebildet.

In der zweiten Ausführungsform gemäß den Figuren 4 bis 6 erstreckt sich die Spulenachse A im Wesentlichen parallel zur Betätigungsrichtung s des berührungsempfindlichen Schaltelements 12. Auch in der ersten Ausführungsform sind Varianten denkbar, bei denen sich die Spulenachse A im Wesentlichen parallel zur Betätigungsrichtung s des berührungsempfindlichen Schaltelements 12 erstreckt, wobei dies maßgeblich von der Formgebung und Anordnung des Hebels 42 abhängt.

Statt dem Magnettopf 30 und dem Magnetjoch 32 gemäß den Figuren 1 und 2 umfasst die Magnetspuleneinheit 20 gemäß den Figuren 4 bis 6 ein Magnetrohr 46, vorzugsweise aus Eisen, sowie ein erstes Magnetjoch 48, vorzugsweise aus Eisen, und ein zweites Magnetjoch 50, ebenfalls vorzugsweise aus Eisen. Das erste Magnetjoch 48 übernimmt hierbei die Funktion des ersten magnetisierbaren Bauteils 22 und das zweite Magnetjoch 50 die Funktion des zweiten magnetisierbaren Bauteils 24. Die Magnetkraft F_{Magnetfixierung} zwischen dem ersten Magnetjoch 48 und dem Dauermagneten 18 in der ersten Endposition (vgl. Figur 4) reicht dabei aus, um den Dauermagneten 18 auch bei unbestromter Magnetspuleneinheit 20 in dieser ersten Endposition zu halten, obwohl das erste Magnetjoch 48 keinen axialen Anschlag für den Dauermagneten 18 ausbildet.

Ein weiterer Unterschied zur ersten Ausführungsform ist die zwischen dem Dauermagneten 18 und dem magnetisierbaren Körper 36 bzw. zweiten Magnetjoch 50 vorgesehene Distanzscheibe 52, die vorzugsweise aus Kunststoff ausgebildet ist. Über diese Distanzscheibe 52 kann die Magnetkraft F_{Magnet} zwischen dem Dauermagnet 18 und dem magnetisierbaren Körper 36 sowie die Magnetkraft F'_{Magnetfixierungt} zwischen dem Dauermagnet 18 und dem zweiten Magnetjoch 50 in der zweiten Endposition des Dauermagneten 18 (vgl. Figuren 5 und 6) mit geringem Aufwand auf einen gewünschten Wert eingestellt werden.

Auch in dieser zweiten Ausführungsform lässt sich der Dauermagnet 18 mittels einer kurzzeitigen Bestromung der Magnetspuleneinheit 20 zwischen seiner ersten Endstellung (Figur 4) und seiner zweiten Endstellung (Figuren 5 und 6) bewegen. Abhängig von diesen Endstellungen des Dauermagneten 18 nimmt das verstellbare Schaltelement 12 die erste Ausgangsstellung gemäß Figur 4 oder die zweite Ausgangsstellung gemäß Figur 5 ein. Je nach Ausgangsstellung des Schaltelements 12 lässt sich die Schaltvorrichtung 10 ohne taktile Rückmeldung (vgl. Figur 4) oder mit taktiler Rückmeldung (vgl. Figuren 5 und 6) berührungssensitiv schalten. Die taktile Rückmeldung vermittelt dem Bediener über einen virtuellen Schaltweg das Gefühl eines traditionellen mechanischen Schaltvorgangs.

## Patentansprüche

1. Schaltvorrichtung, insbesondere in Kraftfahrzeugen, mit
einem verstellbaren, berührungsempfindlichen Schaltelement (12), welches durch einen in einer Betätigungsrichtung (s) ausgeübten Berührdruck schaltbar ist,
wobei das Schaltelement (12) eine erste Ausgangsstellung einnehmen kann, in der sich das Schaltelement (12) in Betätigungsrichtung (s) an einem Widerlager (14) abstützt,
wobei das Schaltelement (12) eine zweite Ausgangsstellung einnehmen kann, in der das Schaltelement (12) gegenüber der ersten Ausgangsstellung um einen vorbestimmbaren Weg (x₁) entgegen der Betätigungsrichtung (s) verstellt ist,
**dadurch gekennzeichnet, dass** ein zwischen zwei Endpositionen bewegbarer Dauermagnet (18) vorgesehen ist, der das Schaltelement (12) entgegen der Betätigungsrichtung (s) vom Widerlager (14) weg beaufschlagen kann.

2. Schaltvorrichtung nach Anspruch 1, **dadurch gekennzeichnet, dass** eine Feder (16) vorgesehen ist, die das Schaltelement (12) in Betätigungsrichtung (s) gegen das Widerlager (14) beaufschlagt.

3. Schaltvorrichtung nach Anspruch 2, **dadurch gekennzeichnet, dass** in einer ersten Endposition des bewegbaren Dauermagneten (18) eine entgegen der Betätigungsrichtung (s) auf das Schaltelement (12) wirkende Magnetkraft (F_{Magnet}) des Dauermagneten (18) kleiner ist als eine in der Betätigungsrichtung (s) auf das Schaltelement (12) wirkende Federkraft (F_{Feder}) der Feder (16).

4. Schaltvorrichtung nach Anspruch 2 oder 3, **dadurch gekennzeichnet, dass** in einer zweiten Endposition des bewegbaren Dauermagneten (18) eine entgegen der Betätigungsrichtung (s) auf das Schaltelement (12) wirkende Magnetkraft (F_{Magnet}) des Dauermagneten (18) größer ist als eine in der Betätigungsrichtung (s) auf das Schaltelement (12) wirkende Federkraft (F_{Feder}) der Feder (16).

5. Schaltvorrichtung nach Anspruch 4, **dadurch gekennzeichnet, dass** die aus dem Berührdruck resultierende, zum Schalten des Schaltelements (12) notwendige Schaltkraft (F_{Schalt}) in der zweiten Endposition des Dauermagneten (18) betragsmäßig im Wesentlichen der Differenz aus Magnetkraft (F_{Magnet}) und Federkraft (F_{Feder}) entspricht.

6. Schaltvorrichtung nach einem der vorhergehenden Ansprüche, **dadurch gekennzeichnet, dass** eine bestrombare Magnetspuleneinheit (20) vorgesehen ist, die eine Spulenachse (A) aufweist, wobei der Dauermagnet (18) wenigstens teilweise in der Magnetspuleneinheit (20) aufgenommen und in axialer Richtung zwischen einer ersten Endposition und einer zweiten Endposition bewegbar ist.

7. Schaltvorrichtung nach Anspruch 6, **dadurch gekennzeichnet, dass** sich die Spulenachse (A) im Wesentlichen parallel zur Betätigungsrichtung (s) des berührungsempfindlichen Schaltelements (12) erstreckt.

8. Schaltvorrichtung nach Anspruch 6 oder 7, **dadurch gekennzeichnet, dass** die Magnetspuleneinheit (20) in der ersten Endposition des Dauermagneten (18) eine andere Induktivität aufweist als in der zweiten Endposition des Dauermagneten, wobei eine Einrichtung (34) zum Messen der Induktivität der Magnetspuleneinheit (20) vorgesehen ist.

9. Schaltvorrichtung nach einem der Ansprüche 6 bis 8, **dadurch gekennzeichnet, dass** ein erstes magnetisierbares Bauteil (22) vorgesehen ist, das den Dauermagneten (18) bei unbestromter Magnetspuleneinheit (20) in einer axialen ersten Endposition durch eine Magnetkraft (F_{Magnetfixierung}) axial fixiert.

10. Schaltvorrichtung nach einem der Ansprüche 6 bis 9, **dadurch gekennzeichnet, dass** ein zweites magnetisierbares Bauteil (24) vorgesehen ist, das den Dauermagneten (18) bei unbestromter Magnetspuleneinheit (20) in einer axialen zweiten Endposition durch eine Magnetkraft (F'_{Magnetfixierung}) axial fixiert.

11. Schaltvorrichtung nach einem der vorhergehenden Ansprüche, **dadurch gekennzeichnet, dass** das berührungsempfindliche Schaltelement (12) mit einem im Wesentlichen koaxial zum Dauermagneten (18) ausgerichteten, axial beweglichen, magnetisierbaren Körper (36) gekoppelt ist.

12. Schaltvorrichtung nach Anspruch 11, **dadurch gekennzeichnet, dass** das berührungsempfindliche Schaltelement (12) an einem ersten Hebelarm (38) und der magnetisierbare Körper (36) an einem zweiten Hebelarm (40) eines zweiarmigen Hebels (42) befestigt sind.

13. Schaltvorrichtung nach Anspruch 11, **dadurch gekennzeichnet, dass** das berührungsempfindliche Schaltelement (12) mit dem magnetisierbaren Körper (36) verbunden und gemeinsam mit dem magnetisierbaren Körper (36) in axialer Richtung bewegbar ist.

## Claims

1. A switching device, in particular in a motor vehicle, comprising
a displaceable touch-sensitive switching element (12) which is switchable by a touch pressure exerted in a direction (s) of actuation,
the switching element (12) being adapted to assume a first initial position, in which the switching element (12) bears on an abutment (14) in the direction (s) of actuation,
the switching element (12) being adapted to assume a second initial position, in which, compared with the first initial position, the switching element (12) is displaced by a predeterminable travel (x₁) contrary to the direction (s) of actuation,
**characterized in that** a permanent magnet (18) is provided which is adapted to be moved between two end positions and which can urge the switching element (12) away from the abutment (14) contrary to the direction (s) of actuation.

2. The switching device according to claim 1, **characterized in that** a spring (16) is provided which urges the switching element (12) against the abutment (14) in the direction (s) of actuation.

3. The switching device according to claim 2, **characterized in that** in a first end position of the movable permanent magnet (18), a magnetic force (F_{magnet}) of the permanent magnet (18) acting on the switching element (12) contrary to the direction (s) of actuation is smaller than a spring force (F_{spring}) of the spring (16) acting on the switching element (12) in the direction (s) of actuation.

4. The switching device according to claim 2 or 3, **characterized in that** in a second end position of the movable permanent magnet (18), a magnetic force (F_{magnet}) of the permanent magnet (18) acting on the switching element (12) contrary to the direction (s) of actuation is greater than a spring force (F_{spring}) of the spring (16) acting on the switching element (12) in the direction (s) of actuation.

5. The switching device according to claim 4, **characterized in that** in the second end position of the permanent magnet (18), the switching force (F_{switching}) resulting from the touch pressure and necessary for switching the switching element (12) substantially corresponds, in terms of amount, to the difference between the magnetic force (F_{magnet}) and the spring force (F_{spring}).

6. The switching device according to any of the preceding claims, **characterized in that** an energizable magnet coil unit (20) is provided which has a coil axis (A), the permanent magnet (18) being at least partly received in the magnet coil unit (20) and being adapted to be moved in the axial direction between first and second end positions.

7. The switching device according to claim 6, **characterized in that** the coil axis (A) extends substantially parallel to the direction (s) of actuation of the touch-sensitive switching element (12).

8. The switching device according to claim 6 or 7, **characterized in that** in the first end position of the permanent magnet (18), the magnet coil unit (20) has a different inductance than in the second end position of the permanent magnet, a device (34) for measuring the inductance of the magnet coil unit (20) being provided.

9. The switching device according to any of claims 6 to 8, **characterized in that** a first magnetizable component (22) is provided which axially fixes the permanent magnet (18) in an axial first end position by a magnetic force (F_{magnet-fixing}) when the magnet coil unit (20) is non-energized.

10. The switching device according to any of claims 6 to 9, **characterized in that** a second magnetizable component (24) is provided which axially fixes the permanent magnet (18) in an axial second end position by a magnetic force (F'_{magnet-fixing}) when the magnet coil unit (20) is non-energized.

11. The switching device according to any of the preceding claims, **characterized in that** the touch-sensitive switching element (12) is coupled to an axially movable, magnetizable body (36) that is oriented substantially coaxially with the permanent magnet (18).

12. The switching device according to claim 11, **characterized in that** the touch-sensitive switching element (12) is attached to a first lever arm (38) and the magnetizable body (36) is attached to a second lever arm (40) of a two-armed lever (42).

13. The switching device according to claim 11, **characterized in that** the touch-sensitive switching element (12) is connected to the magnetizable body (36) and adapted to be moved in the axial direction jointly with the magnetizable body (36).

## Revendications

1. Dispositif de commutation, en particulier dans des véhicules automobiles, comprenant
un élément de commutation (12) tactile et déplaçable, lequel peut être commuté par une pression de contact exercée dans un sens d'actionnement (s),
l'élément de commutation (12) étant apte à prendre une première position initiale dans laquelle l'élément de commutation (12) prend appui sur une butée (14) dans le sens d'actionnement (s),
l'élément de commutation (12) étant apte à prendre une deuxième position initiale dans laquelle l'élément de commutation (12) est déplacé à l'encontre du sens d'actionnement (s) d'un trajet pré-déterminable (x₁) par rapport à la première position initiale,
**caractérisé en ce que**
il est prévu un aimant permanent (18) qui est mobile entre deux positions finales et qui est apte à solliciter l'élément de commutation (12) à l'encontre du sens d'actionnement (s) en éloignement de la butée (14).

2. Dispositif de commutation selon la revendication 1, **caractérisé en ce qu'**il est prévu un ressort (16) qui sollicite l'élément de commutation (12) dans le sens d'actionnement (s) contre la butée (14).

3. Dispositif de commutation selon la revendication 2, **caractérisé en ce que** dans une première position finale de l'aimant permanent (18) mobile, une force magnétique (Fₐᵢₘₐₙₜ) de l'aimant permanent (18) agissant sur l'élément de commutation (12) à l'encontre du sens d'actionnement (s) est inférieure à une force de ressort (Fᵣₑₛₛₒᵣₜ) du ressort (16) agissant sur l'élément de commutation (12) dans le sens d'actionnement (s).

4. Dispositif selon la revendication 2 ou 3, **caractérisé en ce que** dans une deuxième position finale de l'aimant permanent (18) mobile, une force magnétique (Fₐᵢₘₐₙₜ) de l'aimant permanent (18) agissant sur l'élément de commutation (12) à l'encontre du sens d'actionnement (s) est supérieure à une force de ressort (Fᵣₑₛₛₒᵣₜ) du ressort (16) agissant sur l'élément de commutation (12) dans le sens d'actionnement (s).

5. Dispositif de commutation selon la revendication 4, **caractérisé en ce que** la force de commutation (F_{commutatbn}) résultant de la pression de contact et nécessaire pour la commutation de l'élément de commutation (12) correspond dans la deuxième position finale de l'aimant permanent (18) en valeur absolue sensiblement à la différence entre la force magnétique (Fₐᵢₘₐₙₜ) et la force de ressort (Fᵣₑₛₛₒᵣₜ).

6. Dispositif de commutation selon l'une des revendications précédentes, **caractérisé en ce qu'**il est prévu une unité de bobine d'excitation (20) apte à être alimentée en courant qui présente un axe de bobine (A), l'aimant permanent (18) étant au moins en partie reçu dans l'unité de bobine d'excitation (20) et étant mobile dans le sens axial entre une première position finale et une deuxième position finale.

7. Dispositif de commutation selon la revendication 6, **caractérisé en ce que** l'axe de bobine (A) s'étend sensiblement parallèlement au sens d'actionnement (s) de l'élément de commutation (12) tactile.

8. Dispositif de commutation selon la revendication 6 ou 7, **caractérisé en ce que** l'unité de bobine d'excitation (20) présente dans la première position finale de l'aimant permanent (18) une autre inductance que dans la deuxième position finale de l'aimant permanent, un moyen (34) de mesure de l'inductance de l'unité de bobine d'excitation (20) étant prévu.

9. Dispositif de commutation selon l'une des revendications 6 à 8, **caractérisé en ce qu'**il est prévu un premier composant magnétisable (22) qui fixe l'aimant permanent (18) axialement dans une première position finale axiale par une force magnétique (F_{fixationaimant}) lorsque l'unité de bobine d'excitation (20) n'est pas alimentée en courant.

10. Dispositif de commutation selon l'une des revendications 6 à 9, **caractérisé en ce qu'**il est prévu un deuxième composant magnétisable (24) qui fixe l'aimant permanent (18) axialement dans une deuxième position finale axiale par une force magnétique (F'_{fixationaimant}) lorsque l'unité de bobine d'excitation (20) n'est pas alimentée en courant.

11. Dispositif de commutation selon l'une des revendications précédentes, **caractérisé en ce que** l'élément de commutation (12) tactile est couplé à un corps magnétisable (36) axialement mobile qui est orienté de manière sensiblement coaxiale par rapport à l'aimant permanent (18).

12. Dispositif de commutation selon la revendication 11, **caractérisé en ce que** l'élément de commutation (12) tactile est fixé sur un premier bras de levier (38) et **en ce que** le corps magnétisable (36) sur un deuxième bras de levier (40) d'un levier (42) à deux bras.

13. Dispositif de commutation selon la revendication 11, **caractérisé en ce que** l'élément de commutation (12) tactile est relié au corps magnétisable (36) et est mobile dans le sens axial ensemble avec le corps magnétisable (36).
